# EUROPEAN PATENT SPECIFICATION

(11) **EP 1 805 775 B1**
(45) Date of publication and mention of the grant of the patent: **09.07.2008**
(21) Application number: 05851052.0
(22) Date of filing: 26.10.2005
(51) Int. Cl.: H01H 71/12, H01H 83/22, H05K 1/02

(54) **PRINTED CIRCUIT BOARD FOR SAFETY SWITCH AND METHOD FOR MANUFACTURE OF SUCH A PRINTED CIRCUIT BOARD**
LEITERPLATTE FÜR EINEN SICHERHEITSSCHALTER UND VERFAHREN ZUR HERSTELLUNG EINER DERARTIGEN LEITERPLATTE
CARTE DE CIRCUIT IMPRIME POUR INTERRUPTEUR DE SECURITE ET PROCEDE DE FABRICATION D'UNE TELLE CARTE DE CIRCUIT IMPRIME

(30) Priority: 26.10.2004 NL 1027339
(43) Date of publication of application: 11.07.2007
(73) Proprietor: Eaton Electric B.V., 7559 SC Hengelo (NL)
(72) Inventor: HEMMER, Aloysius, Gerardus, Majella, NL-7558 TD Hengelo (NL); NIEHOFF, Ronaldus, Hendrikus, Maria, NL-7577 MB Oldenzaal (NL)
(74) Representative: Hutter, Jacobus Johannes
(86) International application number: PCT/NL2005/050024
(87) International publication number: WO 2006/046870

(56) References cited:
- EP-A- 0 698 895
- FR-A- 2 752 479
- GB-A- 2 109 163
- US-A- 3 950 677
- US-A- 5 757 254
- US-B1- 6 232 857

## Description

### Field of the invention

The present invention relates to a safety switch comprising a printed circuit board, on which, for example, an earth leakage circuit breaker can be located. More particularly the present invention relates to a safety switch according to the preamble of Claim 1. In a further aspect the invention relates to a method for the manufacture of such a safety switch.

### State of the art

Such a safety switch is e.g. known from the publication GB-A-2109163, which discloses a printed circuit board for use in a safety switch.

In existing safety switches use if often made of a separate earth leakage protection device that is added to the safety switch. For this, a conventional printed circuit board, for example made of epoxy, is usually utilised for installing the components and wiring for the earth leakage circuit breaker thereon. Such earth leakage protection for a safety switch is, for example, disclosed in French Patent Application FR-A 2 752 479. In this case all the components, including a monitoring transformer and a trip relay, are mounted on a printed circuit board. However, the Applicant has designed a safety switch where the earth leakage protection is housed in an enclosure of the safety switch that has very small dimensions. As a result of this it was no longer possible to use an earth leakage circuit breaker based on conventional techniques, because there is insufficient space in the enclosure for this.

### Summary of the invention

The present invention seeks to provide a printed circuit board for application in a safety switch that can be used in a very compact safety switch and thus facilitates simple and rapid assembly of the safety switch.

According to the present invention a safety switch of the type defined in the preamble is provided, having the characterising features as described in Claim 1. The printed circuit board is provided with one or more contact pads of a predetermined size and shape, where the contact pads are suitable for making contact by means of contact springs with elements in the safety switch, such as a detector coil, trip actuator, earth connection, contacts on mounting plate. This limits the number of wired links in the enclosure for the switch (wireless design), as a result of which less time is required for assembly of the safety switch. In addition, this makes stacking assembly af the safety switch possible.

The printed circuit board is essentially flat and has a shape that is determined by the other elements in the enclosure, also referred to a contour hybrid. As a result it is also possible, in addition, to include the function of earth leakage protection in the safety switch, with a minimum space requirement, as a result of which the enclosure of the safety switch can be kept within predetermined standard dimensions (for example 90 x 50 x 18 mm).

In one embodiment the printed circuit board is manufactured from ceramic material, such as aluminium oxide. This material provides good heat conduction, as a result of which thermal energy from particular components in the circuit is well dissipated into the printed circuit board and the temperature in the enclosure can still be kept within acceptable limits, despite the small dimensions.

In another embodiment the electronic components on the printed circuit board comprise one or more thick-film resistors. These require only a low height for installation and have a high breakdown voltage in small sizes, as a result of which the dimensions of the printed circuit board (in particular the height) are as small as possible. For the same reason the electronic components on the printed circuit board can comprise one or more high-voltage capacitors, for example applying SMD techniques, in series with a thick-film resistor. This avoids the use of a Class X capacitor, which has relatively large dimensions, whilst voltage spikes of, for example, 6 kV can be tolerated.

In an advantageous embodiment of the printed circuit board electronic components on the printed circuit board are made in the form of surface-mounted components (SMD). This greatly limits the height for installation of the printed circuit board, as a result of which this can be fitted more easily inside the enclosure for the safety switch.

In one embodiment the circuit on the printed circuit board constitutes an earth leakage circuit breaker that has a resistor, for example a power resistor, that is incorporated in a phase circuit of the switch, where the resistor is made in the form of a thick-film resistor on the printed circuit board, and the earth leakage circuit breaker is installed in the safety switch after a short circuit protection device. This arrangement ensures that too high a current can never flow through the resistor in the earth leakage circuit breaker, which extends the life thereof. A resistor, for example a test resistor, incorporated in the earth leakage circuit breaker serves to generate an earth leakage current in a controlled manner and is likewise made in the form of a thick-film resistor. This also results in additional functionality in the circuit on the printed circuit board, whilst only minimum extra space is required.

In another embodiment the earth leakage circuit breaker on the printed circuit board is provided with supply voltage terminals that are electrically connected to a phase and a neutral contact of the safety switch, respectively. By using additional contacts that trail the main contacts, neutral and phase, of the safety switch, the earth leakage circuit breaker is also isolated in the event of the safety switch being switched off. By switching off, the earth leakage circuit breaker is no longer energised, as a result of which earth resistance tests (> 1000 Vdc) and test voltage tests (> 500 Vac) can be carried out without the necessity for further measures, such as disconnecting wires in the safety switch.

In another embodiment the printed circuit board is provided with vias so that electronic components can be mounted on both sides of the printed circuit board. As a result of this the back of the printed circuit board can also be used for additional circuits with additional functionality, without the need for extra space inside the enclosure for the safety switch.

In one embodiment the printed circuit board is provided with an indicator circuit for indicating the operating status of the safety switch. In this way it is possible to add, for example, a LED circuit in conjunction with a light conductor leading to the front of the switch that indicates the operating status of the safety switch and/or the earth leakage circuit breaker.

Another aspect of the present invention relates to a method for the production of a printed circuit board according to the present invention, wherein the method comprises punching out a multiplicity of printed circuit boards of a predetermined shape from a sheet of ceramic source material and curing the sheet to produce the multiplicity of printed circuit boards of finished ceramic material. By this means multiple printed circuit boards of the predetermined shape (contour hybrid) can be obtained from a sheet of source material in an economic manner.

### Brief description of the drawings

The present invention will now be discussed in more detail on the basis of a number of illustrative embodiments, with reference to the apNeutralded drawings, in which
Fig. 1 shows a plan view of a phase side of a safety switch in which a printed circuit board according to one embodiment of the present invention is used;
Fig. 2 shows a plan view of the neutral side of the safety switch in Fig. 1;
Fig. 3 shows a view of a component side of a printed circuit board according to one embodiment of the present invention; and
Fig. 4 shows a partial cross-sectional view of a printed circuit board according to one embodiment of the present invention.

### Detailed description of illustrative embodiments

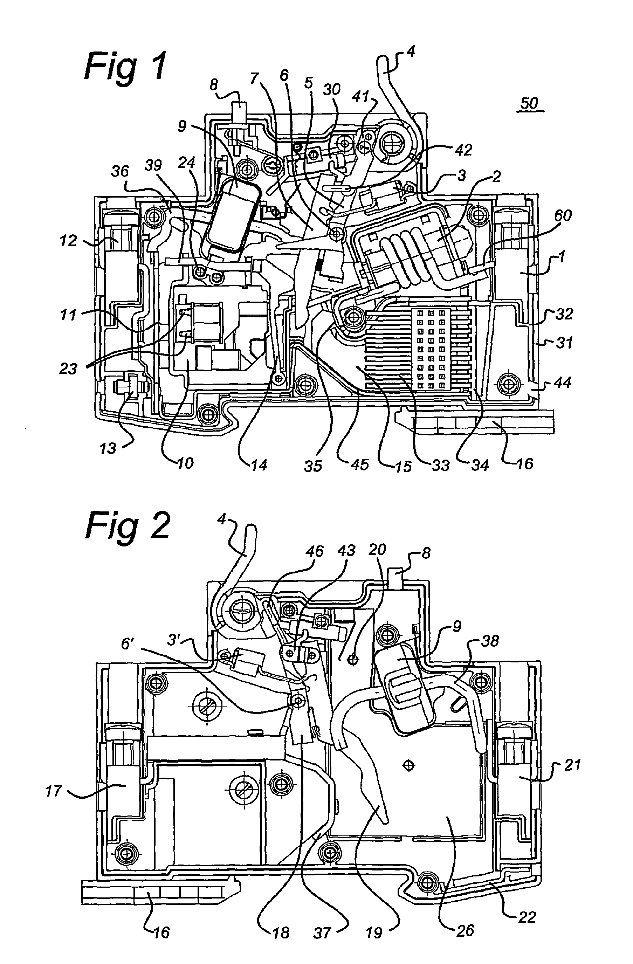

The printed circuit board according to the present invention will now be explained on the basis of one illustrative embodiment. The printed circuit board is advantageously used in a switch 50, one embodiment of which will be described with reference to Figs 1 and 2. However, the printed circuit board in question could also be used in other sorts and types of switches.

Fig. 1 shows a plan view of safety switch 50 according to one embodiment of the present invention. The safety switch 50 combines four functions in one:
- the primary switching function to make or break a circuit;
- the short circuit protection;
- the protection against overloads; and
- the earth leakage protection.

These functions are combined in a switch 50 that is suitable for fixing with the aid of a universal mounting rail, such as a DIN rail. Consequently, for different functions, separate elements or modules (switch, earth leakage protection, etc.) do not have to be installed next to each other and connected electrically. As a result of the special design and build of the various components of the switch 50 according to the present invention, it is not only possible to implement the abovementioned functions inside the standardised DIN module enclosure with a height of 90 mm and a depth of 50 mm but it is even possible to reduce the width of the switch 50 further, certainly in comparison with existing products. In one embodiment the height of the switch is 90 mm and the width 18 mm, with a total volume of 87 cm³. Existing switches, such as the Alamat III range of double-pole switches with automatic earth leakage protection made by the Applicant, have a total volume of 168 cm³. Another type of automatic, single pole earth leakage circuit breaker from a known manufacturer and of a known type has a volume of 106 cm³.

The safety switch 50 as shown in Fig. 1 has an enclosure 31 in two parts. In the plan view in Fig. 1 one part of the enclosure on the phase side of the switch 50 has been omitted. In the plan view in Fig. 2, which shows the neutral side of the switch 50, the part of the enclosure 31 on the neutral side has been omitted. A support element 32 is installed on the inside of the enclosure 31. The various components of the switch 50 are fixed to the support element 32. The support element 32 additionally constitutes a separation (electrical and mechanical) between the phase side and the neutral side of the switch 50. Only in the places where there are relatively thick elements, or elements that are present on both the phase and the neutral side (such as detector coil 9 and on/off knob 4, see below), is there a cut-out in the support element. If there are relatively thick elements on, for example, only the phase side, such as short circuit contact breaker 2 or explosion chamber 15 (see below), a recess can then have been made in the support element 32. The support element also has contact pads where it is possible with the aid of a compression spring or a clip connection to make electrical connections between the various components that can be made and broken easily, as will be described below.

On the phase side (see Fig. 1) there is an incoming phase terminal 1 for attaching an electrical conductor. In the embodiment shown this terminal 1 is of the box terminal type with captive screw in which a connecting wire can be firmly fixed electrically and mechanically. The terminal 1 is connected to a short circuit contact breaker 2. The other side of the short circuit contact breaker 2 supports the fixed contact 35 of the switch 50. The movable contact 7 (or phase contact) is connected via a wire 36 to an overload contact breaker 11 in the form of a bimetal strip. If too high a current flows through the bimetal strip 11 for a long time (for example in the event of sustained current above the nominal value), this will bend as a result of the heat generated and activate a trip mechanism (see below). The phase is conducted further from the bimetal strip to an outgoing phase terminal 12, to which an electrical conductor can be connected analogously to incoming phase terminal 1.

On the NEUTRAL side (see Fig. 2) there is an incoming neutral terminal 17 for attaching an electrical conductor. This neutral terminal 17 is connected via a conductor to a fixed neutral contact 37.The movable neutral contact 19 is connected via a conductor 38 to an outgoing neutral terminal 21, to which, yet again an electrical conductor can be connected. The neutral terminals 17,21 are made as a box terminal with captive screw.

For earth leakage protection, use is made of a detector coil 9 that is connected to an earth leakage circuit breaker on a printed circuit board 26.Both the conductor 36 from the phase circuit and the conductor 38 from the neutral circuit run through the detector coil 9. If it is detected that the magnitude of the current through the phase circuit differs from that though the neutral circuit, it is assumed that there is earth leakage and the earth leakage circuit breaker 26 enables an actuator 10 (trip system) that pushes away a trip lever 14, as a result of which the fixed and moving contacts 7, 35 are moved apart. There are terminal contacts 24 on the support element 32 by means of which the detector coil 9 can be connected to the printed circuit board 26, on which the earth leakage circuit breaker is installed. There are also terminal contacts 23 that connect the earth leakage circuit breaker on the printed circuit board 26 to the trip system 10. By this means it is possible to install the printed circuit board 26 on the neutral side of the support element 32 and the trip system 10 on the phase side of the support element 32.

The earth leakage circuit breaker is located on the printed circuit board 26 which is shaped such that this fits in a flat space on the support element 32 that remains alongside the spaces that are taken up by the relatively thick elements, such as the detector coil 9 (in an open space in the support element 32), the short circuit contact breaker 2 (in a recessed space on the phase side of the support element 32) and the explosion chamber (in a recessed space on the phase side of the support element 32). Preferably the printed circuit board 26 is installed on the neutral side of the support element 32.

The printed circuit board 26 can be fixed with the aid of holes and corresponding pins in the support element 32 or enclosure 31. As an alternative the printed circuit board 26 can also be fixed with a clip that can be fitted in the enclosure 31 and by means of which the printed circuit board 26 is held against the support element 32. Preferably the clip is shaped such that an explosion chamber for the neutral contacts is formed between the clip and the enclosure. In the event of an arc being produced between the neutral contacts 19, 37 the arc will then be driven away and extinguished by the formation of hot gasses and by their flow induced by the shape of the explosion chamber. For the sake of clarity the clip is not shown in fig. 2. but the clip covers most of the printed circuit board 26 and part of the support element 32 as well in the vicinity of the neutral contacts 19, 37.

According to the present invention the printed circuit board 26 is made of a ceramic material such as aluminium oxide. Such a material affords good heat conduction, certainly in comparison with conventional printed circuit board materials such as epoxy, as a result of which electronic components on the printed circuit board 26 will be less likely to get (too) hot.

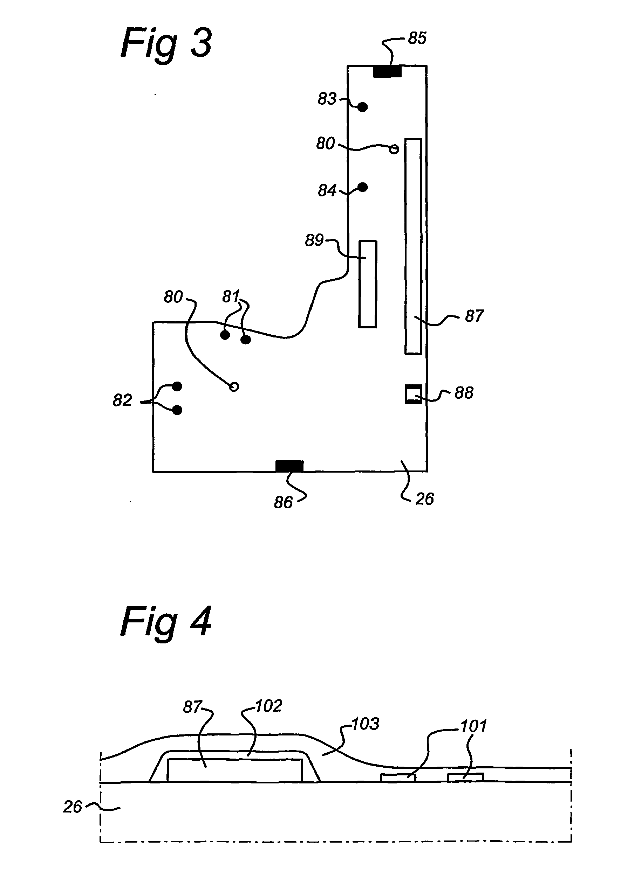

The shape of the printed circuit board 26 is dictated by the other elements in the enclosure 31 for the switch 50 and is often referred to by the term contour hybrid. The production of printed circuit board 26 from ceramic material with such a shape is not simple. A conventional production process, where a scored edge or laser perforated edge is used to enable separation of the individual printed circuit boards after curing, is not suitable. According to one aspect of the present invention, a multiplicity of printed circuit boards 26 is punched out of a sheet of raw, untreated ceramic material before the curing process. For example, nine printed circuit boards with the shape shown in Fig. 3 can be punched out of a sheet of source material with little loss. During the curing process it is possible that the shape of an individual printed circuit board 26 changes somewhat. This is taken into account in the design of the layout of the circuit on the printed circuit board 26. A characteristic of the process is that the source material shrinks substantially (30 % to 40 % is possible). As a result of the variation in shrinkage, determined by the starting material and the curing process, the size of the end product, the printed circuit board 26, is subject to tolerance. This dimensional tolerance can be taken care of by preselecting, that is to say before application of the track pattern, two or more size categories of prints and then additionally matching the layouts (track patterns) to these size categories by also distinguishing corresponding categories therein.

The printed circuit board 26 also affords the possibility of making a thick-film resistor on the printed circuit board 26 with the aid of a suitable paste. Various commercially available products are suitable for this, as is known to a person skilled in the art. A thick-film resistor 87, 89 is shown in the plan view in Fig. 3. This thick-film resistor 87, 89 has a very high voltage rating for a small size. The characteristics of the thick-film resistor 87, 89 can be adjusted with the aid of special measures, even after production on the printed circuit board 26.

The thick-film resistor 87, 89 is first applied with the aid of a screen printing process. This process is fairly crude and consequently it is difficult to achieve an accurate resistance value. For this reason, resistance values of e.g. nominal minus 20 % are taken as the starting point in the design and manufacturing process, after which a small cut with the aid of a laser (laser cut) is made to adjust (trim) the value to the nominal value. In order to insulate the resistor 87, 89 better and make it capable of withstanding peak voltages, a thin layer of glass 102 is applied over the resistor 87, 89, as shown in the partial cross-sectional view in Fig. 4. Trimming of the resistor 87, 89 can be done after applying the glass layer 102. In addition, in order to reduce the insulation distances, a lacquer layer 103 can be applied over the resistors 87, 89 and paths 101, so that the conventional creep and air passages can be substantially reduced. This makes compact construction possible.

The thick-film resistors 87, 89 can be used in the supply section of the earth leakage circuit breaker to trap (high-)voltage peaks in the mains in which the safety switch 50 is located. The test resistor that is needed to be able to test the earth leakage circuit breaker with the test button 8 in a controlled manner can also be made I the form of a thick-film resistor. In addition, a test resistor that is used to measure the current through the phase circuit of the switch 50 can also be made in the form of a thick-film resistor.

Ceramic high-voltage capacitors 88 are also used on the printed circuit board 26, preferably as surface-mounted devices. By coupling these high-voltage capacitors in series with a thick-film resistor, it is possible to avoid having to use special Class X capacitors which are, per se, capable of withstanding high peak voltages (of, for example, 6 kV). By using a power supply of a largely capacitive design, the inherent consumption of the switch 50 will remain low.

The use of SMD components (surface-mounted components) for all components of the earth leakage circuit breaker on the printed circuit board 26 makes it possible to keep the installation height of the printed circuit board 26 in the enclosure 31 low, as a result of which this is easier to fit in. There is then also space left over, for example on the back of the printed circuit board 26, for accommodating additional circuits. Possible required connections with the other side of the printed circuit board 26 can be implemented by means of vias in the printed circuit board 26.

A possible addition could be a circuit that indicates in which region the earth leakage circuit breaker is operating. For instance, by using, for example, one or more LEDs in this circuit, a green colour can be used to indicate a safe status because no or a very small (e.g. < 7.5 mA) earth leakage is detected, an orange or yellow colour to indicate that an earth leakage current has been detected that remains within a predetermined zone (e.g. > 7.5 mA < 15 mA) and thus is still within acceptable limits, and a red colour when the danger zone (e.g. > 15 mA , < 22 mA) has been exceeded and a dangerous situation has arisen, but the earth leakage protection has not yet switched off the switch 50. The LEDs could be installed on the printed circuit board 26 and the light produced by the LEDs could, for example, be directed to the front (control panel) of the switch by means of a light conductor.

From the electrical standpoint, earth leakage circuit breaking on the printed circuit board 26 is preferably incorporated in the safety switch downstream of the short circuit contact breaker 2. In this way the earth leakage circuit breaker will be protected against excessive currents as a result of short circuiting or overload.

The electrical connections between the components of the switch 50 are (as far as possible) formed by a combination of contact pads and contact springs, or by clip connections in the support element 32. By this means it is possible to realise good electrical connection and, at the same time, to keep the assembly of the switch 50 very simple.

In the embodiment shown the electrical connections that have to be made with the printed circuit board 26 are formed with the aid of contact islands 81... 86 on the printed circuit board 26. For instance, there are two contact islands 81 for making a connection with the detector coil 9, two contact islands 82 for making a connection with the actuator or trip system 10, two supply terminals 83, 84. There can also be additional contacts, for example contact island 85 that provides the connection with test button 8 and a contact island 86 that provides a connection with an optional earth lead 22. Conductor springs (not shown) enable good contact between contact islands on the printed circuit board 26 and further connections with other components of the switch 50 (directly or via, for example, the support element 32). The springs can, for example, be premounted in the support element 32, as a result of which it is possible to assemble the switch 50 by stacking. This avoids the use of wire conductors, which would have to be soldered to the printed circuit board 26 by hand. Furthermore, soldering of wire conductors to the printed circuit board 26 would be difficult because the ceramic printed circuit board 26 is a good conductor of heat. The islands 81 ... 86 are tin-plated silver/platinum islands and the springs are made of tin-plated steel or tin-plated phosphor bronze so that the electrical contact runs via a tin-tin junction. The tin oxide skin that may develop is easy to break through (by making contact) and consequently this connection is reliable in the longer term.

The printed circuit board 26 can be fixed in the enclosure 31 for the safety switch 50 with the aid of pins on the support element 32 and holes 80 in the printed circuit board 26. As an alternative the printed circuit board 26 is clamped between the enclosure 31 and support element 32 using a pressure plate (not shown).

The modular build of the switch 50 that enables assembly by stacking, also makes it possible to remove or replace the printed circuit board 26 in a simple manner. This can be necessary in connection with replacement of a faulty circuit, or replacement of the existing circuit by a circuit that offers more and/or other functions.

The earth leakage circuit breaker on the printed circuit board 26 according to the present embodiment is provided with supply voltage terminals (contact islands 83 and 84) that are electrically connected to a phase and a neutral contact 7, 19, respectively, of the safety switch 50. This is, for example, implemented by a pair of additional contacts that trail the moving contacts 7,19 (neutraL and phase), as a result of which the complete earth leakage circuit breaker is also isolated in the event of the safety switch 50 being switched off. By switching off the switch 50, the earth leakage circuit breaker is then no longer energised, as a result of which earth resistance tests (> 1000 Vdc) and test voltage tests (> 500 Vac) can be carried out on the safety switch 50 without the necessity for further measures. After all, in existing switch layouts, wiring to an earth leakage circuit has to be disconnected, because otherwise the high voltages that are associated with earth resistance testing and test voltage testing of the safety switch 50 could damage the components of the earth leakage circuit breaker.

Of course, merely breaking or, alternatively, disconnecting the phase side of the supply for the earth leakage circuit breaker could suffice. However, in order to have the functionality described above in all the embodiments of the safety switch to be described below (even in the case where there is an earth terminal 22), there are advantages in switching both the phase and the neutral connections.

One embodiment of the safety switch 50 is possible where no neutral circuit is interrupted, as a result of which the operating mechanism can be simpler (fixed neutral contact 37, moving neutral contact 19, neutral trip lever 18, spring 3' and incoming neutral terminal 17 can then be omitted). The earth leakage circuit breaker does obviously need a permanent reference in order to be able to detect an earth leakage current. This can then be provided by a neutral contact or an earth terminal 22 (see Fig. 2) to which an external earth lead can be connected. The earth terminal 22 is then connected to the printed circuit board 29, for example using a spring contact This type of switch is also referred to as 'solid Neutral'.

Although embodiments of the printed circuit board 26 according to the present invention have been explained above on the basis of an example of a safety switch, such as shown in Figs 1 and 2, it will be clear to a person skilled in the art that this printed circuit board 26 can also be used in other types of switches where only a very limited space within the enclosure is available.

## Claims

1. Safety switch comprising a printed circuit board (26), where the printed circuit board (26) is provided with electronic components which make up a circuit for enabling a predetermined function of the safety switch (50), wherein the safety switch (50) comprises an enclosure (31) housing elements of the safety switch (50), wherein the printed circuit board (26) is essentially flat and has a shape that is determined by the other elements in the enclosure (31), in which the printed circuit board (26) is provided with one or more contact pads (81 ... 86) of a predetermined size and shape, **characterised in that** the elements of the safety switch (50) comprise a plurality of contact springs, and **in that** the contact pads (81 ... 86), in assembled state of the safety switch, make contact with further elements in the safety switch (50) by means of the plurality of contact springs.

2. Safety switch according to Claim 1, wherein the printed circuit board (26) is manufactured from ceramic material, such as aluminium oxide.

3. Safety switch according to one of the preceding claims, wherein the electronic components on the printed circuit board (26) comprise one or more thick-film resistors (87, 89).

4. Safety switch according to one of the preceding claims, wherein the electronic components on the printed circuit board (26) comprise one or more high-voltage capacitors (88) in series with a thick-film resistor.

5. Safety switch according to one of the preceding claims, wherein electronic components on the printed circuit board (26) are made in the form of surface-mounted components.

6. Safety switch according to one of the preceding claims, wherein the circuit on the printed circuit board (26) is an earth leakage circuit breaker that has a resistor that is incorporated in a phase circuit of the switch, where the resistor is made in the form of a thick-film resistor on the printed circuit board (26), and the earth leakage circuit breaker is installed in the safety switch after a short circuit protection device (2).

7. Safety switch according to Claim 6, wherein the earth leakage circuit breaker has a resistor for generating an earth leakage current in a controlled manner and the resistor is made in the form of a thick-film resistor.

8. Safety switch according to Claim 6 or 7, wherein the earth leakage circuit breaker on the printed circuit board is provided with supply voltage terminals that are electrically connected to a phase and a NEUTRAL contact of the safety switch (50), respectively.

9. Safety switch according to one of the preceding claims, wherein the printed circuit board (26) is provided with vias so that electronic components can be mounted on both sides of the printed circuit board (26).

10. Safety switch according to one of the preceding claims, wherein the printed circuit board (26) is provided with an indicator circuit for indicating the operating status of the safety switch (50).

11. Method for the production of a safety switch according to one of Claims 1 to 10, **characterised by**
- punching out a multiplicity of printed circuit boards (26) of a predetermined shape from a sheet of ceramic source material;
- curing the sheet to produce the multiplicity of printed circuit boards (26) of finished ceramic material.

## Patentansprüche

1. Ein Sicherheitsschalter, der eine Leiterplatte (printed circuit board) (26) aufweist, wobei die Leiterplatte (26) versehen ist mit elektronischen Komponenten, die eine Schaltung bilden zum Ermöglichen einer vorbestimmten Funktion von dem Sicherheitsschalter (50), wobei der Sicherheitsschalter (50) eine Einhausung (31) aufweist, die Elemente von dem Sicherheitsschalter (50) aufnimmt, wobei die Leiterplatte (26) im Wesentlichen flach ist und eine Form besitzt, die durch die anderen Elemente in der Einhausung (31) bestimmt wird, wobei die Leiterplatte (26) versehen ist mit einem oder mehreren Kontaktfeldern bzw. Pads (81...86) von einer vorbestimmten Größe und Form, **dadurch gekennzeichnet, dass** die Elemente von dem Sicherheitsschalter (50) eine Vielzahl von Kontaktfedern aufweisen und dadurch, dass die Kontaktfelder (81...86) im zusammengebauten Zustand von dem Sicherheitsschalter Kontakt herstellen mit weiteren Elementen in dem Sicherheitsschalter (50) mittels der Vielzahl von Kontaktfedern.

2. Sicherheitsschalter gemäß Anspruch 1, wobei die Leiterplatte (26) aus keramischem Material, wie beispielsweise Aluminium-Oxid hergestellt ist.

3. Sicherheitsschalter gemäß einem der vorhergehenden Ansprüche, wobei die elektronischen Komponenten von der Leiterplatte (26) einen oder mehrere Dickfilmwiderstände (87, 89) aufweisen.

4. Sicherheitsschalter gemäß einem der vorhergehenden Ansprüche, wobei die elektronischen Komponenten von der Leiterplatte (26) einen oder mehrere Hochspannungskondensatoren (88) in Reihe mit einem Dickfilmwiderstand aufweisen.

5. Sicherheitsschalter gemäß einem der vorhergehenden Ansprüche, wobei die elektronischen Komponenten von der Leiterplatte (26) in der Form von Oberflächen montierten Komponenten hergestellt sind.

6. Sicherheitsschalter gemäß einem der vorhergehenden Ansprüche, wobei die Schaltung auf der Leiterplatte (26) ein Erdleck-Schutzschalter bzw. - Lasttrenner ist, der einen Widerstand besitzt, der in einer Phasenschaltung bzw. in einem Phasenkreis von dem Schalter einbezogen ist, wobei der Widerstand in der Form von einem Dickfilmwiderstand auf der Leiterplatte (26) hergestellt ist und der Erdleck-Lasttrenner in dem Sicherheitsschalter nach einer Kurzschluss-Schutzeinrichtung (2) installiert ist.

7. Sicherheitsschalter gemäß Anspruch 6, wobei der Erdleck-Lasttrenner einen Widerstand besitzt zum Erzeugen eines Erdleckstroms auf eine kontrollierte Art und Weise und der Widerstand in der Form von einem DickfilmWiderstand hergestellt ist.

8. Sicherheitsschalter gemäß Anspruch 6 oder 7, wobei der Erdleck-Lasttrenner auf der Leiterplatte versehen ist mit Versorgungsspannungsanschlüssen, die elektrisch mit einem Phasen- bzw. einem Neutral-Kontakt von dem Sicherheitsschalter (50) verbunden sind.

9. Sicherheitsschalter gemäß einem der vorhergehenden Ansprüche, wobei die Leiterplatte (26) versehen ist mit Durchkontaktierungen, so dass elektronische Komponenten auf beiden Seiten von der Leiterplatte (26) befestigt werden können.

10. Sicherheitsschalter gemäß einem der vorhergehenden Ansprüche, wobei die Leiterplatte (26) versehen ist mit einer Indikatorschaltung zum Anzeigen des Betriebsstatus von dem Sicherheitsschalter (50).

11. Verfahren zur Produktion von einem Sicherheitsschalter gemäß einem der Ansprüche 1 bis 10, **gekennzeichnet durch**:
- Herausstanzen einer Vielzahl von Leiterplatten (26) von einer vorher bestimmten Form aus einem Bogen bzw. einer Platte aus keramischem Ausgangsmaterial;
- Härten des Bogens zum Erzeugen der Vielzahl von Leiterplatten (26) aus fertig gestellten keramischen Material.

## Revendications

1. Interrupteur de sécurité comprenant une carte de circuit imprimé (26), où la carte de circuit imprimé (26) est dotée de composants électroniques qui composent un circuit permettant une fonction prédéterminée de l'interrupteur de sécurité (50), où l'interrupteur de sécurité (50) comprend un coffret (31) recevant des éléments de l'interrupteur de sécurité (50), où la carte de circuit imprimé (26) est essentiellement plate et a une forme qui est déterminée par les autres éléments dans le coffret (31), où la carte de circuit imprimé (26) est pourvue d'une ou plusieurs pastilles de contact (81...86) d'une taille et d'une forme prédéterminées, **caractérisé en ce que** les éléments de l'interrupteur de sécurité (50) comprennent une pluralité de ressorts de contact, et **en ce que** les pastilles de contact (81...86), dans un état assemblé de l'interrupteur de sécurité, établissent un contact avec des éléments additionnels dans l'interrupteur de sécurité (50) au moyen de la pluralité de ressorts de contact.

2. Interrupteur de sécurité de la revendication 1, dans lequel la carte de circuit imprimé (26) est fabriquée à partir d'un matériau en céramique, tel qu'un oxyde d'aluminium.

3. Interrupteur de sécurité selon l'une des revendications précédentes, dans lequel les composants électroniques de la carte de circuit imprimé (26) comprennent une ou plusieurs résistances à couches épaisses (87, 89).

4. Interrupteur de sécurité selon l'une des revendications précédentes, dans lequel les composants électroniques de la carte de circuit imprimé (26) comprennent un ou plusieurs condensateurs à haute tension (88) en série avec une résistance à couches épaisses.

5. Interrupteur de sécurité selon l'une des revendications précédentes, dans lequel des composants électroniques de la carte de circuit imprimé (26) sont faits sous la forme de composants montés en surface.

6. Interrupteur de sécurité selon l'une des revendications précédentes, dans lequel le circuit sur la carte de circuit imprimé (26) est un disjoncteur de fuite à la terre qui a une résistance qui est incorporée dans un circuit de phase de l'interrupteur, où la résistance est faite sous la forme d'une résistance à couches épaisses sur la carte de circuit imprimé (26), et le disjoncteur de fuite à la terre est installé dans l'interrupteur de sécurité après un dispositif de protection contre les courts circuits (2).

7. Interrupteur de sécurité selon la revendication 6, dans lequel le disjoncteur de fuite à la terre a une résistance pour générer un courant de fuite à la terre de manière commandée et la résistance est élaborée sous la forme d'une résistance à couches épaisses.

8. Interrupteur de sécurité selon la revendication 6 ou 7, dans lequel le disjoncteur de fuite à la terre sur la carte de circuit imprimé est doté de bornes de tension d'alimentation qui sont connectées électriquement à une phase et un contact du NEUTRE de l'interrupteur de sécurité (50), respectivement.

9. Interrupteur de sécurité selon l'une des revendications précédentes, dans lequel la carte de circuit imprimé (26) est pourvue de trous d'interconnexion de sorte que des composants électroniques peuvent être montés sur les deux faces de la carte de circuit imprimé (26).

10. Interrupteur de sécurité selon l'une des revendications précédentes, dans lequel la carte de circuit imprimé (26) est dotée d'un circuit indicateur pour indiquer l'état opérationnel de l'interrupteur de sécurité (50).

11. Procédé de fabrication d'un interrupteur de sécurité selon l'une des revendications 1 à 10, **caractérisé par** le fait de
découper plusieurs cartes de circuits imprimés (26) d'une forme prédéterminée à partir d'une feuille d'un matériau source en céramique;
durcir la feuille afin de produire les plusieurs cartes de circuits imprimés (26) d'un matériau en céramique fini.
